Europäisches Patentamt

**European Patent Office**

Office européen des brevets

(11) Numéro de publication: **0 275 778**
**B1**

(12) **FASCICULE DE BREVET EUROPEEN**

(19)

(45) Date de publication du fascicule du brevet:
16.08.90

(21) Numéro de dépôt: **87402952.3**

(22) Date de dépôt: **22.12.87**

(51) Int. Cl.⁵: **H01L 21/78**

(54) **Procédé de découpe collective, par voie chimique, de dispositifs semiconducteurs, et dispositif découpé par ce procédé.**

(30) Priorité: **29.12.86 FR 8618299**

(43) Date de publication de la demande:
**27.07.88 Bulletin 88/30**

(45) Mention de la délivrance du brevet:
**16.08.90 Bulletin 90/33**

(84) Etats contractants désignés:
**DE GB NL**

(56) Documents cités:
**EP-A- 0 052 309**
**US-A- 3 973 320**

**JOURNAL OF THE ELECTROCHEMICAL SOCIETY,
vol. 124, no. 9, septembre 1977, pages 1462-1463, Manchester, New York, US; B.M. ARMSTRONG et al.: "A
technique for fabricating oxide passivated BARITT
diodes"**

(73) Titulaire: **THOMSON HYBRIDES ET MICROONDES,
173, bld Haussmann, F-75008 Paris(FR)**

(72) Inventeur: **Turina Mallard, Nathalie, THOMSON-CSF
SCPI 19, avenue de Messine, F-75008 Paris(FR)**
Inventeur: **Lleti, Georges, THOMSON-CSF
SCPI 19, avenue de Messine, F-75008 Paris(FR)**

(74) Mandataire: **Taboureau, James et al, THOMSON-CSF
SCPI, F-92045 Paris La Défense Cédex 67(FR)**

**Description**

La présente invention concerne un procédé de découpe de dispositifs semiconducteurs de très petites dimensions, montés sur un dissipateur d'or intégré. Les dispositifs semiconducteurs concernés par l'invention sont essentiellement les diodes, fabriquées de façon collective sur une tranche de matériaux semiconducteurs : leur séparation en éléments discrets intervient, selon le procédé de l'invention, par une découpe chimique de la tranche.

Les diodes concernées par ce procédé de découpe chimique peuvent être de différents types : à jonction, Schottky, PIN, IMPATT... etc, et être réalisées sur silicium ou sur matériaux de la famille III-V tels que GaAs ou InP par exemple. Par très petites dimensions, il faut entendre que les puces de chaque diode ont environ 200 microns de côté : ce sont donc essentiellement des diodes hyperfréquences, bien que le procédé soit applicable aux diodes basse fréquence de faible puissance et donc de petites dimensions.

Certaines applications nécessitent que chaque diode comprenne une semelle intégrée en or qui fait office de dissipateur thermique. Cette semelle est fixée sur une embase d'un métal bon conducteur électrique et thermique, qui est le radiateur proprement dit.

Jusqu'à présent la réalisation de telles diodes était obtenue par un processus collectif, mais la séparation finale de chaque composant discret était effectuée par découpe mécanique. En effet, la découpe au moyen d'un rayon laser n'est pas possible à cause de la semelle d'or. La découpe mécanique par lames tranchantes est donc utilisée mais reste très délicate puisque les puces ont environ 200 microns de côté : c'est une opération peu précise, longue, et par conséquent coûteuse.

Selon l'invention, les diodes sont fabriquées sur un substrat semiconducteur, puis des témoins de profondeur constante sont gravés dans les tranches semiconductrices : les témoins doivent traverser la où les couches actives de la diode et pénétrer jusque dans le substrat. La surface de la couche active et les trous des témoins sont recouverts d'une couche d'accrochage pour les semelles d'or qui sont ensuite créées, après masquage approprié. Une épaisse couche d'un métal attaquable chimiquement est déposée sur toute la face de la plaquette, qui est alors rodée mécaniquement par sa face substrat semiconducteur jusqu'à apparition des extrémités enterrées des témoins de profondeur. Il ne reste à ce moment que la (ou les) couche(s) active(s) et une faible épaisseur de substrat. Les métallisations de prise de contact sont déposées, selon des techniques connues, aux emplacements adéquats sur ce qui reste du substrat, puis la gravure chimique des mésas, pour chaque diode, s'arrête sur les semelles d'or. On a donc réalisé une plaquette de métal qui supporte une pluralité de diodes mésas fixées chacune sur leur semelle d'or. L'attaque chimique de la plaquette de métal permet de séparer les diodes en éléments discrets.

De façon plus précise, l'invention concerne un procédé de de découpe collective, par voie chimique, de dispositifs semiconducteurs, fixés sur une semelle d'or de très petites dimensions (200 microns), comportant une étape préliminaire de réalisation d'au moins une couche semiconductrice sur un substrat en matériau semiconducteur, formant une jonction de diode, ce procédé étant caractérisé en ce qu'il comporte les étapes suivantes :

1) - gravure de témoins de profondeur dans la couche semiconductrice, tous les témoins ayant même profondeur et pénétrant dans le substrat, à raison d'au moins un témoin entre deux futures diodes,

2) - dépôt, sur la couche semiconductrice et dans les trous des témoin d'une couche métallique d'accrochage sur le matériau semiconducteur

3) - masquage sur la couche d'accrochage et gravure du masque en vue de dégager les fenêtres correspondant aux futures semelles d'or,

4) - dépôt électrolytique des semelles d'or dans les fenêtres du masque,

5) - dissolution du masque et dépôt d'une couche métallique d'arrêt de diffusion, sur les semelles d'or et les parties apparentes de la couche d'accrochage

6) - croissance sur la couche anti-diffusion d'une couche épaisse d'un métal support mécanique, attaquable par une solution chimique qui n'attaque pas l'or,

7) - amincissement du substrat semiconducteur jusqu'à apparition des témoins de profondeur

8) - masquage du substrat semiconducteur, gravure du masque, et dépôt des métallisations de prises de contact sur les diodes

9) - gravure des mésas des diodes 10) - découpe chimique collective en éléments discrets par attaque chimique de la couche de métal support mécanique et de la couche d'accrochage.

L'invention sera mieux comprise et ses avantages ressortiront de la description d'un exemple de réalisation de découpe chimique, cette description s'appuyant sur les figures jointes en annexe qui représentent :

- figure 1 : une diode sur semelle d'or selon l'art connu,
- figure 2 : une diode sur semelle d'or selon l'invention,
- figures 3 à 11 : les différentes étapes du procédé de fabrication et de découpe chimique selon l'invention,
- figure 12 : une diode découpée selon le procédé de l'invention, vue en plan.

Bien que l'invention s'applique généralement à tous les dispositifs semiconducteurs de petites dimensions, qu'ils soient fabriqués sur silicium ou sur matériau de type III-V, et que les diodes ainsi fabriquées puissent comporter une couche active, comme c'est le cas pour une diode à jonction, ou une pluralité de couches, comme c'est le cas pour les diodes PIN, l'invention sera exposée sur l'exemple d'une diode à jonction en silicium, de façon à simplifier le texte et les figures et à rendre l'invention plus facilement compréhensible.

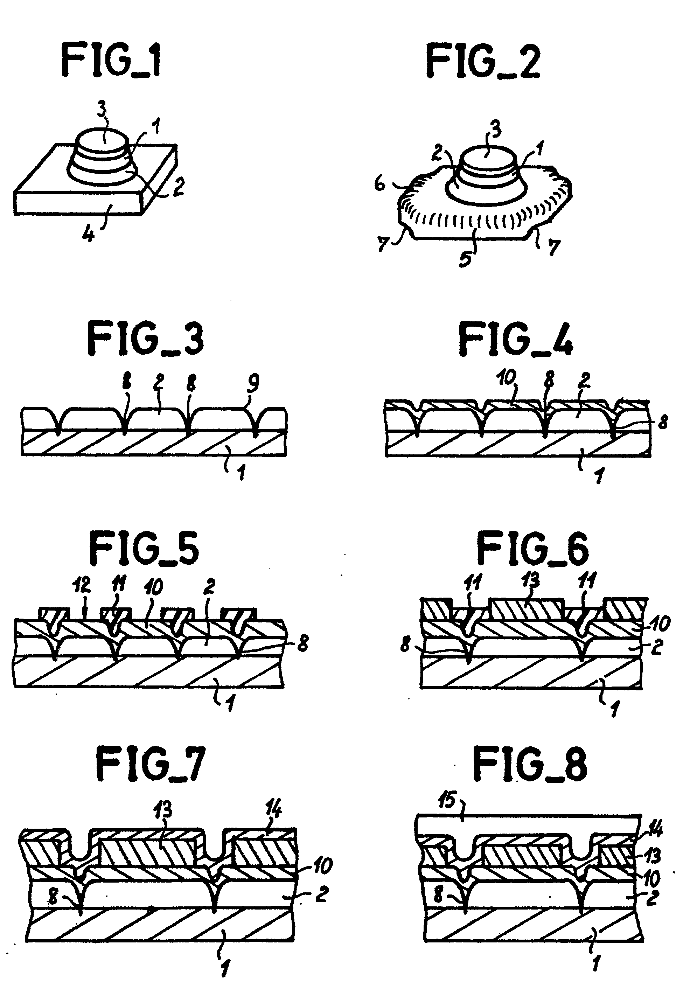

La figure 1 représente une vue de trois quart dans l'espace d'une diode sur semelle d'or, selon l'art connu. Une telle diode comporte au moins une jonction entre deux couches 1 et 2 de matériaux de conductivités opposées, et, lorsque la nécessité de l'application exige que la diode soit montée sur une semelle d'or, elle est gravée en mésa. Les contacts électriques sont pris par une métallisation 3 sur le sommet de la mésa, et par l'intermédiaire de la semelle d'or 4, qui est ensuite soudée sur un support, généralement en cuivre qui sert à refroidir la diode en fonctionnement. La structure d'une telle diode exige que la semelle d'or soit réalisée en cours de fabrication, car il est aisément concevable qu'on ne peut pas souder une pastille de diode aussi petite sur une semelle d'or qui serait fabriquée séparément.

Par conséquent le problème de la découpe des diodes qui sont fabriquées collectivement est lié à la présence de la semelle d'or, qui interdit l'utilisation d'un laser et l'automatisation de la découpe au niveau d'une tranche semiconductrice, mais il est également lié aux très petites dimensions des diodes hyperfréquences. Les diodes sur semelle d'or selon l'art connu sont donc découpées mécaniquement, au moyen d'une lame, ce qui donne au socle ou semelle d'or 4 des dimensions carrées ou rectangulaires, et la découpe fournit des aretes vives.

La diode sur semelle d'or selon l'invention, représentée sur la figure 2, comprend une partie semiconductrice qui est comparable à la diode de l'art connu. Elle est formée par la jonction entre deux couches de matériau 1 et 2, de types de conductivités opposées, une métallisation 3 étant déposée sur le sommet de la mésa. Mais la semelle d'or 5, découpée chimiquement, présente une double particularité. D'une part elle ne comporte pas d'arête vive, mais est arrondie sur ses bords en 6, de telle sorte qu'il n'y a qu'une seule surface qui passe de la face supérieure à la face inférieure de la semelle d'or sans arête vive : cette surface se recourbe, et l'arrondi des bords de la semelle est une conséquence du procédé de fabrication qui sera exposé plus loin. D'autre part les coins de la semelle d'or 5 présentent des traces en 7 qui sont les restes des témoins de gravure : la présence des coins tronqués de la semelle d'or 5 s'expliquera mieux par l'exposé du procédé de fabrication et de découpe chimique qui va suivre.

Pour fabriquer des diodes, par un procédé collectif, et les découper chimiquement, le procédé de l'invention part d'une tranche de substrat semiconducteur 1 sur laquelle on fait croitre une couche d'un matériau semiconducteur 2 ou - bien que cela ne soit pas représenté sur la figure - une pluralité de couches s'il s'agit par exemple d'une diode PIN. La couche 2, qui a été déposé par épitaxie constituera la future couche active de chaque diode. On grave alors des témoins de profondeur 8 dans la plaquette semiconductrice, à partir de la face supportant la couche active, et ces témoins doivent être assez profonds pour pénétrer jusque dans le substrat 1. Si la couche active a par exemple une épaisseur de 1 micron, chaque motif est gravé sur une épaisseur de 5 microns, et il peut y avoir 4 motifs pour localiser une diode, aux quatre coins de la future semelle d'or. Mais on peut également concevoir qu'il y ait moins de témoins de profondeur 8, à raison de 1 témoin entre 4 diodes par exemple. Ceci n'est pas représenté sur la figure 3, mais il est évident que ces témoins sont gravés sur toute la plaquette semiconductrice selon une grille régulièrement maillée. La gravure chimique des témoins de profondeur 8 se fait selon les règles connues de la cristallographie et au moyen d'une solution chimique appropriée, mais il reste que au cours de cette attaque chimique, les angles en 9 des motifs mis en évidence dans la couche active 2 sont arrondis, ce qui est le propre de toute attaque chimique.

Les témoins de profondeur peuvent être de diverses formes, et vus en plan, ce peut être soit des cercles, ce qui donne donc un trou 8 en forme de tronc de cône, soit des croix ce qui donne donc des trous 8 en forme cruciforme.

L'opération suivante représentée en figure 4 consiste à déposer une couche 10 de métallisation par un métal d'accrochage du dissipateur métallique sur le matériau semiconducteur. Cette couche d'accrochage, déposée sur la couche active 2, peut être par exemple en chrome / platine / or, ou la chaine bien connue silicium / platine - titane - platine - or. Cette couche métallique 10 remplit les trous des témoins de profondeur 8, et pénètre donc jusque dans le substrat 1.

Par des techniques connues, la couche de métal d'accrochage 10 est alors recouverte par une couche de masquage qui est soit en résine photosensible, soit minérale c'est à dire en silice, ou en nitrure de silicium, ou en nitrure d'aluminium... etc. Cette couche est alors gravée pour ne laisser que des ilôts 11, qui sont de forme maillée, et qui laissent apparaître entre leurs mailles des trous 12 qui correspondent aux futures semelles d'or.

De façon à mieux montrer les détails de la structure, la figure 6 et les figures suivantes ne représentent plus que la région d'une rondelle qui correspond à une diode, représentée à plus grande échelle.

L'opération suivante consiste donc à faire une croissance électrolytique d'or sur les zones non masquées, par conséquent dans les ouvertures 12. Cette croissance électrolytique d'or fournit donc une semelle d'or 13, qui a pu croitre en raison de la présence de la couche métallique d'accrochage 10.

Le masque de résine ou de silice 11 est alors éliminé par les solvants appropriés, et par conséquent la face côté couche active de la rondelle de matériau semiconducteur sera, après dissolution du masque 11, entièrement métallique, et comportera soit les semelles d'or 13, soit les parties apparentes de la couche d'accrochage métallique 10.

En figure 7, l'opération consiste à déposer, du côté métallique de la plaquette une couche 14 de nickel, qui constitue une barrière de diffusion, afin d'éviter la diffusion, dans l'or des semelles 13, du cuivre ou de tout autre métal usuel, tels que l'étain, l'argent, le plomb, le fer. Cette couche de cuivre, représentée en 15 sur la figure 8, est suffisamment épaisse pour constituer un substrat rigide pour la suite des opérations. Cependant le cuivre peut être remplacé par un autre métal, à la condition que ce métal soit attaqué par une solution chimique, sans que l'or des semelles 13 soit attaqué.

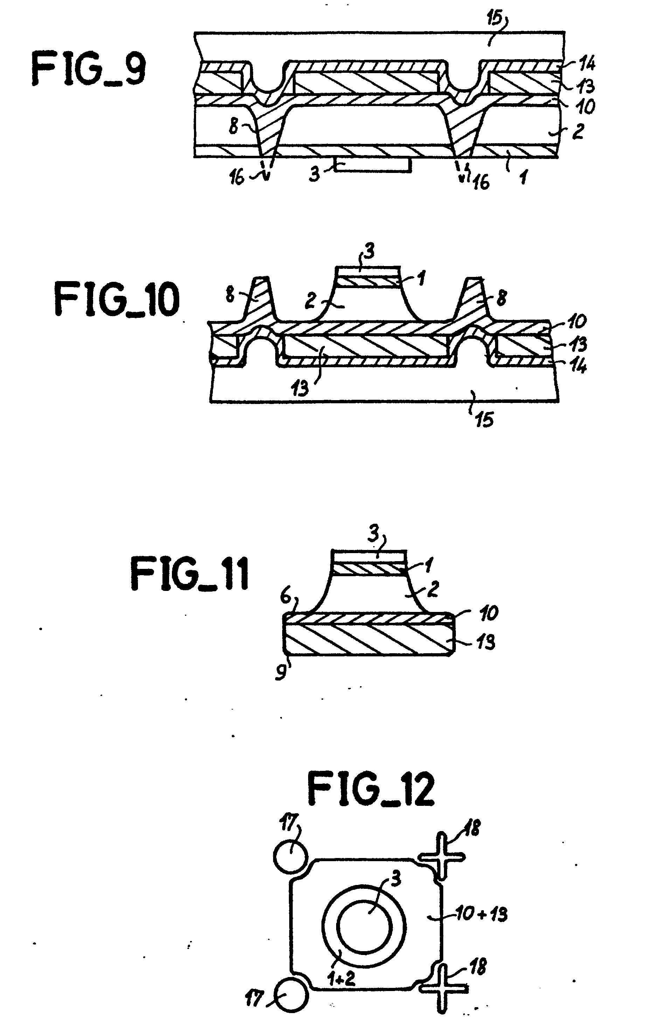

En figure 9, la couche de métal 15 servant alors de support métallique à la pluralité des diodes qui y adhèrent, le substrat semiconducteur 1 est rodé jusqu'à ce que la pointe ou l'extrémité enterrée 16 des témoins de profondeur 8 apparaisse. L'amincissement du substrat 1 peut être également pratiqué par voie chimique ou par un plasma. Cet amincissement s'arrête lorsqu'on voit apparaitre les extrémités 16 des témoins de profondeur, représentés en pointillé, et ceci nécessite donc que les témoins de profondeur soient tous réalisés avec une grande régularité pour assurer la régularité de l'épaisseur de la couche restante du substrat 1.

Par des procédés connus, et qu'il n'est donc pas nécessaire de détailler, la face libre de ce qui reste du substrat 1 est alors masquée, et les métallisations 3 de prise de contact sur la diode sont déposées aux endroits adéquats.

Puis, la plaquette étant retournée sur la figure 10, chaque diode est isolée au moyen de la gravure d'une mésa, la métallisation 3 servant de masque de gravure. A ce point de la fabrication collective des diodes, une plaquette comporte donc un support mécanique 15, en cuivre ou étain ou argent... etc sur lequel sont fixées des diodes mésas, chacune étant centrée sur sa semelle d'or 13. Cependant entre les diodes apparaissent les témoins de profondeur 8 qui n'ont pas été gravés au cours de l'opération de gravure des mésas.

La séparation des puces intervient par une attaque du cuivre du support 15 et du nickel de la couche de barrière de diffusion 14, au moyen d'acide nitrique, à 70°C, en solution normale. Cette attaque est favorisée par l'action combinée d'ultra-sons, et elle dure 30 minutes environ. Cependant d'autres solutions que l'acide nitrique peuvent être utilisées, et toutes les solutions chimiques qui attaquent les métaux conviennent à la condition qu'elles n'attaquent pas l'or, ni les matériaux semiconducteurs de la diode 1 + 2.

Au cours de cette attaque chimique, et comme représenté en figure 11, l'arête 6 de la couche métallique d'accrochage 10 est légèrement attaquée ce qui lui donne une forme arrondie. Par ailleurs, et découlant de l'attaque chimique des témoins de profondeur 8 qui avaient des angles arrondis 9 la semelle d'or 13 possède elle-même des angles arrondis, et il n'y a pas d'arete vive dans la semelle de la diode ainsi réalisée et séparée chimiquement. C'est donc la même surface qui par courbure forme la surface supérieure et la surface inférieure de la semelle d'or 13, et cette semelle ne possède pas d'arete vive comme dans le cas de l'art connu.

En outre, comme représenté dans la figure 12, la semelle d'or possède des particularités dans ses angles. Cette figure représente une diode, munie d'une semelle d'or découpée chimiquement par le procédé de l'invention, vue en plan. Sur la partie de gauche sont représentées les traces de deux témoins de profondeur 17 qui ont une section circulaire, tandis que sur la partie de droite de la figure sont représentées les traces de deux témoins de profondeur 18 qui ont une section cruciforme. Au cours des différentes opérations de masquage puis de gravure, au long du procédé, ces témoins ont laissé une trace qui se retrouve dans les angles de la semelle d'or, cette semelle d'or étant très généralement de forme carrée. Dans le cas présent la semelle d'or découpée chimiquement a des coins qui sont d'une forme qui rappelle la présence des témoins de profondeur au cours du processus de fabrication : les coins de la semelle d'or reproduisent le profil des témoins de profondeur 17 ou 18 selon le cas. En outre il n'est pas nécessaire que les quatre coins soient ainsi marqués par la trace des témoins de profondeur et il peut n'y avoir qu'un seul coin marqué, si par exemple on a décidé de mettre un témoin de profondeur à l'intersection de quatre pastilles de diodes. Toutefois il est évident que le processus est mené avec beaucoup plus de précision s'il y a un témoin de profondeur à chaque coin de diode.

Le procédé qui vient d'être décrit n'est pas limité à la seule application qui en a été faite, mais toutes les modifications qui entrent dans le domaine de l'invention et qui sont évidentes pour l'homme de l'art, telle que par exemple la séparation par découpe chimique de diodes en InP, ou de diodes comportant une pluralité de couches actives, appartiennent au domaine de l'invention, qui est précisée par les revendications suivantes.

**Revendications**

1. Procédé de découpe collective, par voie chimique, de dispositifs semiconducteurs, fixés sur une semelle d'or de très petites dimensions (200 microns), comportant une étape préliminaire de réalisation d'au moins une couche semiconductrice (2) sur un substrat (1) en matériau semiconducteur, formant une jonction de diode, ce procédé étant caractérisé en ce qu'il comporte les étapes suivantes :

1) - gravure de témoins de profondeur (8) dans la couche semiconductrice (2), tous les témoins (8) ayant même profondeur et pénétrant dans le substrat (1), à raison d'au moins un témoin (8) entre deux futures diodes,

2) - dépôt, sur la couche semiconductrice (2) et dans les trous des témoins (8) d'une couche métallique (10) d'accrochage sur le matériau semiconducteur (1, 2)

3) - masquage (11) sur la couche d'accrochage (10) et gravure du masque en vue de dégager les fenêtres (12) correspondant aux futures semelles d'or,

4) - dépôt électrolytique des semelles d'or (13) dans les fenêtres (12) du masque (11),

5) - dissolution du masque (11) et dépôt d'une couche métallique (14) d'arrêt de diffusion, sur les semelles d'or (13) et les parties apparentes de la couche d'accrochage (10)

6) - croissance sur la couche (14) anti-diffusion d'une couche épaisse d'un métal (15) support mécanique, attaquable par une solution chimique qui n'attaque pas l'or,

7) - amincissement du substrat semiconducteur (1) jusqu'à apparition des témoins de profondeur (8)

8) - masquage du substrat semiconducteur (1), gravure du masque, et dépôt des métallisations (3) de prises de contact sur les diodes

9) - gravure des mésas des diodes (1 + 2 + 3)

10) - découpe chimique collective en éléments discrets par attaque chimique de la couche de métal support mécanique (15) et de la couche d'accrochage (10).

2. Procédé selon la revendication 1, caractérisé en ce que la couche d'accrochage (10) de la semelle d'or (13) sur le matériau semiconducteur (2) est constituée par la chaine métallique Si Pt/Ti/Pt/Au ou par Cr/Pt/Au.

3. Procédé selon la revendication 1, caractérisé en ce que le masque (11) de réalisation des semelles d'or (13) est organique ou minéral, en silice, nitrure de silicium, nitrure d'aluminium.

4. Procédé selon la revendication 1, caractérisé en ce que la couche barrière de diffusion (14) est en nickel.

5. Procédé selon la revendication 1, caractérisé en ce que la couche épaisse de métal (15) de support mécanique est en un métal attaquable chimiquement par une solution qui n'attaque pas l'or, tel que cuivre, ou étain, ou argent.

6. Procédé selon la revendication 5, caractérisé en ce que la solution d'attaque chimique de la couche épaisse (15) est une solution normale d'acide nitrique à 70 ° C, pendant 30 minutes, avec activation par ultra-sons.

7. Dispositif semiconducteur fixé sur une semelle d'or (13), découpé par voie chimique selon le procédé de la revendication 1, caractérisé en ce qu'une surface courbe (en 6 et 9) joint les deux surfaces principales de la semelle d'or (13), sans arêtes vives.

8. Dispositif semiconducteur fixé sur une semelle d'or (13), découpé par voie chimique selon le procédé de la revendication 1, caractérisé en ce que au moins un angle de la semelle d'or (13) porte la trace (7) d'au moins un témoin de profondeur (17 ou 18).

**Patentansprüche**

1. Verfahren zum chemischen gemeinsamen Zerteilen von Halbleiterbauelementen, die auf einer Fußplatte aus Gold mit sehr kleinen Abmessungen (200 Mikrometer) befestigt sind, mit einer vorbereitenden Stufe der Realisation wenigstens einer halbleitenden Schicht (2) auf einem Substrat (1) aus einem Halbleitermaterial, wodurch ein Diodenübergang ausgebildet wird, dadurch gekennzeichnet, daß es die folgenden Schritte umfaßt:

1) - Ätzung von Tiefenbezugsmaßen (e) in der halbleitenden Schicht (2) in einer Menge von wenigstens einem Bezugsmaß (8) zwischen zwei künftigen Dioden, wobei sämtliche Bezugsmaße (8) die gleiche Tiefe besitzen und in das Substrat (1) eindringen,

2) - Niederschlag einer Haftmetallschicht (10) zum Haften auf dem Halbleitermaterial (1, 2) auf der halbleitenden Schicht (2) und in den Löchern der Bezugsmaße (8),

3) - Maskierung (11) auf der Haftschicht (10) und Ätzung der Maske, um die den künftigen Fußplatten aus Gold entsprechenden Fenster (12) freizulegen,

4) - elektrolytische Abscheidung von Fußplatten aus Gold (13) in den Fenstern (12) der Maske (11),

5) - Ablösung der Maske (11) und Abscheidung einer metallischen Diffusionssperrschicht (14) auf den Fußplatten aus Gold (13) und den offenliegenden Teilen der Haftschicht (10),

6) - Aufwachsenlassen einer dicken Metallschicht (15) als mechanische Auflage, die von einer das Gold nicht angreifenden chemischen Lösung angreifbar ist, auf der Antidiffusionsschicht (14),

7) - Verkleinerung des Halbleitersubstrats (1), bis die Tiefenbezugsmaße (8) erscheinen,

8) - Maskierung des Halbleitersubstrats (1), Ätzung der Maske und Abscheidung von Anschlußkontaktmetallisierungen (3) auf den Dioden,

9) - Ätzung der Kontakttische der Dioden (1 + 2 + 3),

10) - chemisches gemeinsames Zerteilen in diskrete Elemente durch chemisches Angreifen der als mechanische Auflage dienenden Metallschicht (15) und der Haftschicht (10).

2. Verfahren gemäß Anspruch 1, dadurch gekennzeichnet, daß die Haftschicht (10) der Fußplatte aus Gold (13) auf dem Halbleitermaterial (2) von der Metallverbindung Si Pt/Ti/Pt/Au oder von Cr/Pt/Au aufgebaut wird.

3. Verfahren gemäß Anspruch 1, dadurch gekennzeichnet, daß die Maske (11) zur Herstellung der Fußplatten aus Gold (13) organisch oder mineralisch, aus Kieselerde, aus Siliziumnitrid, aus Aluminiumnitrid ist.

4. Verfahren gemäß Anspruch 1, dadurch gekennzeichnet, daß die Diffusionssperrschicht (14) aus Nickel ist.

5. Verfahren gemäß Anspruch 1, dadurch gekennzeichnet, daß die dicke Metallschicht (15), die als mechanische Auflage dient, ein Metall ist, das von einer Lösung, die das Gold nicht angreift, chemisch angreifbar ist, wie etwa Kupfer oder Zinn oder Silber.

6. Verfahren gemäß Anspruch 5, dadurch gekennzeichnet, daß die Lösung zum chemischen Angreifen der dicken Schicht (15) eine Normallösung von Salpetersäure ist, bei 70°C, während 30 Minuten, mit Ultraschallaktivierung.

7. Halbleiterbauelement, das auf einer Fußplatte aus Gold (13) befestigt und gemäß dem Verfahren des Anspruchs 1 chemisch zerteilt ist, dadurch gekennzeichnet, daß die zusammengefügten zwei Hauptoberflächen der Fußplatte aus Gold (13) eine gekrümmte Oberfläche (bei 6 und 9) ohne scharfe Kanten ergeben.

8. Halbleiterbauelement, das auf einer Fußplatte aus Gold (13) befestigt und gemäß dem Verfahren des Anspruchs 1 chemisch zerteilt ist, dadurch gekennzeichnet, daß wenigstens eine Ecke der Fußplatte aus Gold (13) die Spur (7) wenigstens eines Tiefenbezugsmaßes (17 oder 18) trägt.

## Claims

1. A collective chemical cutting method for the separation of semiconductor devices secured to a base of gold with very small dimensions (200 microns), comprising a preliminary stage for producing at least one semiconductor layer (2) on a substrate (1) of semiconductor material, forming a diode junction, said method being characterized in that it comprises the following steps:

1) – etching depth markers (8) in the semiconductor layer (2), all said markers (8) having the same depth and penetrating the substrate (1), there being at least one marker (8) between two eventual diodes,

2) – the deposition, on the semiconductor layer (2) and in the holes of the markers (8), of a metallic attachment layer (10) on the semiconductor material (1 and 2),

3) – masking (11) on the attachment layer (10) and etching the mask for the purpose of opening up windows (12) corresponding to the eventual gold bases,

4) – the electrolytic deposition of the gold bases (13) in the windows (12) of the mask (11),

5) – dissolving the mask (11) and the deposition of a diffusion preventing metallic layer (14) on the gold bases (13) and the visible parts of the attachment layer (10),

6) – the growth on the anti-diffusion layer (14) of a thick layer of mechanical support metal (15) able to be attacked by a chemical solution which does not attack gold,

7) – reduction of the thickness of the semiconductor substrate (1) until depth markers (8) appear,

8) – masking of the semiconductor substrate (1), etching of the mask and deposition of metallized areas (3) on the diodes as contact means, 9) – etching diode mesas (1 + 2 + 3),

10) – and collective chemical cutting up into separate elements by chemical attack of the mechanical support metal layer (15) and of the attachment layer (10),

2. The method as claimed in claim 1, characterized in that the attachment layer (10) of the gold base (13) on the semiconductor material (2) is constituted by the metallic series Si Pt/Ti/Pt/Au or by Cr/Pt/Au.

3. The method as claimed in claim 1, characterized in that the mask (11) for the production of the gold bases (13) is organic or inorganic, of silica, silicon nitride, aluminum nitride.

4. The method as claimed in claim 1, characterized in that the diffusion preventing layer (14) is made of nickel.

5. The method as claimed in claim 1, characterized in that the thick mechanical support metal layer (15) is made of a metal, such as copper, tin or silver, able to be attacked chemically by a solution which does not attack gold.

6. The method as claimed in claim 5, characterized in that the solution for chemically attacking – for a time of 30 minutes, with activation by ultra-sound – the thick layer (15) is a normal solution of nitric acid at 70°C.

7. A semiconductor device attached to a gold base (13) and separated by chemical action using the method as claimed in claim 1, characterized in that a curved surface (at 6 and that) joins the two principal surfaces of the gold base (13) without sharp edges.

8. The semiconductor device attached to a gold base (13) and separated by chemical action using the method as claimed in claim 1, characterized in that at least one angled part of the gold base (13) carries the trace (7) of at least one depth marker (17 or 18).

FIG_1

FIG_2

FIG_3

FIG_4

FIG_5

FIG_6

FIG_7

FIG_8

FIG_9

15

14
13
10
2

8

16    3    16    1

FIG_10

3

1

8    2    8

10
13
14

13

15

FIG_11

3

1

2

6

10
13

9

FIG_12

17

18

3

10+13

1+2

17

18